# EUROPÄISCHE PATENTANMELDUNG

(11) **EP 1 168 444 A2**
(43) Veröffentlichungstag der Anmeldung: **02.01.2002**
(21) Anmeldenummer: 01440177.2
(22) Anmeldetag: 20.06.2001
(51) Int. Cl.: H01L 23/66

(54) **Elektronisches oder opto-elektronisches Baulement mit einer Verpackung aus Kunstoff und Verfahren zur Variation der Impedanz einer Anschlussleitung eines solchen Baulements**

(30) Priorität: 30.06.2000 DE 10031843
(71) Anmelder: ALCATEL, 75008 Paris (FR)
(72) Erfinder: Ferling, Dieter, 70199 Stuttgart (DE)
(74) Vertreter: Wörz, Volker

(57) **Zusammenfassung**

Die Erfindung betrifft ein elektrisches oder opto-elektrisches Bauelement (1, 11) mit einer Verpackung (2, 12) aus Kunststoff, mindestens einem in der Verpackung (2, 12) angeordneten elektrischen oder opto-elektrischen integrierten Schaltkreis (3, 13) und aus der Verpackung (2, 12) herausragenden Anschlussleitungen (4, 14) zum Anschluss des oder jeden Schaltkreises (3, 13). Um auf eine möglichst einfache Weise die Impedanz (Z) der Anschlussleitungen (4, 14) zu verringern, wird vorgeschlagen, dass mindestens eine dielektrische Platte (6, 16', 16") an mindestens einer der Anschlussleitungen (4, 14) befestigt ist. Die dielektrischen Platten (6, 16) sind vorzugsweise im Inneren der Verpackung (2, 12) angeordnet und bestehen vorzugsweise aus Keramik, insbesondere aus Aluminiumoxid.

## Beschreibung

Die vorliegende Erfindung betrifft ein elektrisches oder opto-elektrisches Bauelement mit einer Verpackung aus Kunststoff. In der Verpackung ist mindestens ein elektrischer oder opto-elektrischer integrierter Schaltkreis angeordnet. Aus der Verpackung ragen Anschlussleitungen zum Anschluss des oder jeden Schaltkreises heraus. Mit Hilfe der Anschlussleitungen kann der oder jeder Schaltkreis beispielsweise mittels eines Sockels oder mittels einer Lötverbindung auf einer Leiterplatte befestigt und in eine auf der Leiterplatte ausgebildete Schaltung integriert werden. Die vorliegende Erfindung betrifft außerdem ein Verfahren zur Variation der Impedanz einer Anschlussleitung eines solchen elektrischen oder opto-elektrischen Bauelements.

Elektrische oder opto-elektrische Bauelemente der eingangs genannten Art sind aus dem Stand der Technik bekannt. Der in der Verpackung eines solchen Bauelements angeordnete integrierte Schaltkreis kann für unterschiedlichste Applikationen, beispielsweise für ein Speicherelement oder einen Mikroprozessor, ausgelegt sein. Anordnung und Abmessung der Anschlussleitungen (sog. Pins) der Bauelemente sind weitgehend standardisiert. Derartige Bauelemente werden insbesondere in Schaltungen eingesetzt, die relativ langsam bzw. bei einer relativ niedrigen Frequenz arbeiten. Bei Hochgeschwindigkeits-Anwendungen mit einer Verarbeitungsgeschwindigkeit von mehreren Gb/s und bei Hochfrequenz-Anwendungen von mehreren GHz muss impedanzkontrolliert gearbeitet werden, d.h. die Impedanz der Bauelemente der Schaltung, die Impedanz der Leiterbahnen der Schaltung, die Impedanz der Anschlussleitungen und die Impedanz der Schaltkreise müssen in etwa gleich groß sein. Durch unterschiedliche Impedanzen könnte es bei Hochgeschwindigkeits- und Hochfrequnez-Anwendungen nämlich zu störenden Signal-Reflexionen in den Schaltkreisen oder in der Schaltung auf der Leiterplatte kommen.

Die Impedanz der Leiterbahnen auf der Leiterplatte, der anderen auf der Leiterplatte angeordneten Bauelemente und der Schaltkreise kann ohne große Anstrengungen auf einen etwa gleich großen Wert eingestellt werden. Typischerweise beträgt deren Impedanz etwa 25 Ω oder 50 Ω. Lediglich die Kontaktierungsverbindungen (z. B. Bonding-Drähte) zwischen den Schaltkreisen und den Anschlussleitungen des Bauelements und die Anschlussleitungen selbst weisen eine davon abweichende höhere Impedanz auf.

Zur Verringerung von störenden Signal-Reflexionen wäre es erforderlich, die Impedanz der Anschlussleitungen auf die Impedanz der Schaltung, in die das Bauelement integriert ist, und der Schaltkreise zu reduzieren. Bei den bekannten Bauelementen mit einer Verpackung aus Kunststoff kann die Impedanz der Anschlussleitungen jedoch nicht einfach variiert bzw. reduziert werden, da Anordnung, Abmessung und Abstand der Anschlussleitungen zueinander vorgegeben sind. Es kommt hinzu, dass bei den bekannten Bauelementen ein Verringern der Impedanz der Anschlussleitungen auf etwa 25 Ω oder 50 Ω durch Verändern der Anordnung, der Abmessung oder des Abstandes der Anschlussleitungen - wenn überhaupt - nur mit extrem hohen produktionstechnischen Anforderungen möglich wäre. Diese hohen produktionstechnischen Anforderungen ergeben sich beispielsweise daraus, dass der Abstand zwischen zwei nebeneinander angeordneten Anschlussleitungen bei einer auf 25 Ω oder 50 Ω reduzierten Impedanz der Anschlussleitungen so klein wäre, dass die Anschlussleitungen mit herkömmlichen Stanzwerkzeugen kaum noch herstellbar wären.

Aus dem Stand der Technik sind elektrische oder opto-elektrische Bauelemente mit einer Verpackung aus Keramik oder Metall bekannt. Bei diesen Bauelementen kann die Impedanz der Anschlussleitungen variiert und auf die Impedanz der Schaltung, in die das Bauelement integriert ist, und der Schaltkreise reduziert werden. Die Herstellung der Bauelemente mit Keramik- oder Metall-Verpackung ist jedoch sehr aufwendig und teuer.

Aufgabe der vorliegenden Erfindung ist es deshalb, eine möglichst einfache und kostengünstige Möglichkeit zur Variation, insbesondere zur Reduzierung, der Impedanz von Anschlussleitungen eines elektrischen oder opto-elektrischen Bauelements mit einer Verpackung aus Kunststoff zur Verfügung zu stellen.

Zur Lösung dieser Aufgabe schlägt die Erfindung ausgehend von dem Bauelement der eingangs genannten Art vor, dass mindestens eine dielektrische Platte an mindestens einer der Anschlussleitungen befestigt ist.

Wenn man das Ersatzschaltbild von zwei unmittelbar nebeneinander angeordneten Anschlussleitungen (sog. Pins) des Bauelements betrachtet, weist dieses in Längsrichtung der Anschlussleitungen verlaufende Induktivitäten und zwischen nebeneinander angeordneten Anschlussleitungen Kapazitäten auf. Die Impedanz einer Anschlussleitung ist proportional zu der Quadratwurzel des Quotienten aus Induktivität und Kapazität, d. h. durch eine Erhöhung der zwischen zwei Anschlussleitungen wirkenden Kapazität kann die Impedanz einer Anschlussleitung verringert werden. Erfindungsgemäß wird vorgeschlagen, die Kapazität zwischen den Anschlussleitungen dadurch zu erhöhen, dass mindestens eine dielektrische Platte an den Anschlussleitungen befestigt wird. Die Kapazität kann durch die Wahl des Materials und damit der Permittivitätszahl (Dielektrizitätskonstante) der dielektrischen Platte und durch Variation der Abmessungen der dielektrischen Platte variiert werden. Durch eine geeignte Wahl des Materials und der Abmessungen der dielektrischen Platte kann die Impedanz der Anschlussleitungen auf einen gewünschten Wert eingestellt werden.

Es wäre denkbar, die dielektrischen Platten außerhalb der Verpackung an den Anschlussleitungen zu befestigen. Gemäß einer vorteilhaften Weiterbildung der vorliegenden Erfindung wird jedoch vorgeschlagen, dass die oder jede dielektrische Platte in der Verpackung an der oder jeder Anschlussleitung befestigt ist. Dadurch wird verhindert, dass die dielektrischen Platten aus Versehen von den Anschlussleitungen entfernt werden, und das erfindungsgemäße Bauelement wird besser handhabbar. Zudem lässt sich das Bauelement gemäß dieser Weiterbildung besonders einfach und kostengünstig herstellen, indem im Rahmen des Herstellungsschrittes zur Herstellung der Kunststoffverpackung des Bauelements der mit den Anschlussleitungen kontaktierte Schaltkreis zusammen mit den an den Anschlussleitungen anliegenden dielektrischen Platten mit Kunststoff vergossen wird.

Gemäß einer bevorzugten Ausführungsform der vorliegenden Erfindung wird vorgeschlagen, dass die oder jede dielektrische Platte eine höhere Permittivitätszahl (Dielektrizitätskonstante) als der Kunststoff der Verpackung aufweist. Vorteilhafterweise besteht die oder jede dielektrische Platte aus Keramik, vorzugsweise aus Aluminiumoxid (Al₂O₃).

Gemäß einer anderen vorteilhaften Weiterbildung der vorliegenden Erfindung wird vorgeschlagen, dass die Verpackung seitlich über die Anschlussleitungen gezogen ist. Die Anschlussleitungen verlaufen also im Inneren der Verpackung zunächst horizontal von dem Schaltkreis weg und knicken dann vertikal nach unten ab, um schließlich an der Unterseite des Bauelementes aus der Verpackung herauszutreten. Es ist auch denkbar, dass die Anschlussleitungen aus der Vertikalen noch einmal in die Horizontale abknicken und erst dann seitlich aus der Verpackung heraustreten. Bei dieser Weiterbildung ist entscheidend, dass die Anschlussleitungen über einen möglichst großen Bereich hinweg innerhalb der Verpackung verlaufen und von Kunststoff umgeben sind. Die Permittivitätszahl von Kunststoff, das die Anschlussleitungen nahezu auf ihrer gesamten Länge umgibt, ist größer als die Permittivitätszahl von Luft, die bei herkömmlichen Bauelementen einen Großteil der Anschlussleitungen umgibt. Deshalb weisen die Anschlussleitungen des Bauelements gemäß dieser Weiterbildung eine verringerte Impedanz auf, selbst wenn keine dielektrischen Platten an den Anschlussleitungen befestigt sind. Die dielektrischen Platten können an einer beliebigen Stelle der Anschlussleitungen, vorzugsweise im Inneren der Verpackung, an den Anschlussleitungen befestigt werden.

Um die Kapazität zwischen den Anschlussleitungen weiter zu erhöhen, wird gemäß einer weiteren bevorzugten Ausführungsform der vorliegenden Erfindung vorgeschlagen, dass die den Anschlussleitungen abgewandte Oberfläche der oder jeder dielektrischen Platte zumindest teilweise mit einer Metallschicht beschichtet ist. Gemäß dieser Weiterbildung bilden die Anschlussleitungen und die Metallschicht mit der dazwischen angeordneten dielektrischen Platte gewissermaßen einen Plattenkondensator.

Vorteilhafterweise sind zwei dielektrische Platten an den Anschlussleitungen befestigt. Eine der dielektrischen Platten kann an den im Inneren der Verpackung horizontal verlaufenden Bereichen der Anschlussleitungen und die andere dielektrische Platte an den sich vertikal nach unten erstreckenden Bereichen der Anschlussleitungen befestigt sein.

Gemäß der vorliegenden Erfindung wird auch die Verwendung einer dielektrischen Platte zur Variation der Impedanz einer Anschlussleitung eines elektrischen oder opto-elektrischen Bauelements vorgeschlagen. Das Bauelement weist eine Verpackung aus Kunststoff, mindestens einen in der Verpackung angeordneten elektrischen oder opto-elektrischen integrierten Schaltkreis und mehrere aus der Verpackung herausragende Anschlussleitungen zum Anschluss des oder jeden Schaltkreises auf. Zur Variation der Impedanz der Anschlussleitung wird die dielektrische Platte an der Anschlussleitung befestigt.

Als eine weitere Lösung der Aufgabe der vorliegenden Erfindung wird ausgehend von dem Verfahren der eingangs genannten Art vorgeschlagen, dass mindestens eine dielektrische Platte an mindestens einer der Anschlussleitungen befestigt wird.

Weitere Merkmale, Anwendungsmöglichkeiten und Vorteile der Erfindung ergeben sich aus der nachfolgenden Beschreibung von Ausführungsbeispielen der Erfindung, die in der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung. Es zeigen:
- Figur 1: ein erfindungsgemäßes elektrisches oder optoelektrisches Bauelement gemäß einer ersten bevorzugten Ausführungsform in einer Ansicht von oben teilweise im Schnitt;
- Figur 2: das erfindungsgemäße Bauelement aus Figur 1 in einem Querschnitt entlang der Linie II-II;
- Figur 3: ein Ersatzschaltbild für die Impedanz von Anschlussleitungen des Bauelements aus Figur 1;
- Figur 4: zwei Anschlussleitungen des erfindungsgemäßen Bauelements aus Figur 1 im Querschnitt entlang der Linie IV-IV; und
- Figur 5: ein erfindungsgemäßes elektrisches oder optoelektrisches Bauelement gemäß einer zweiten bevorzugten Ausführungsform im Querschnitt.

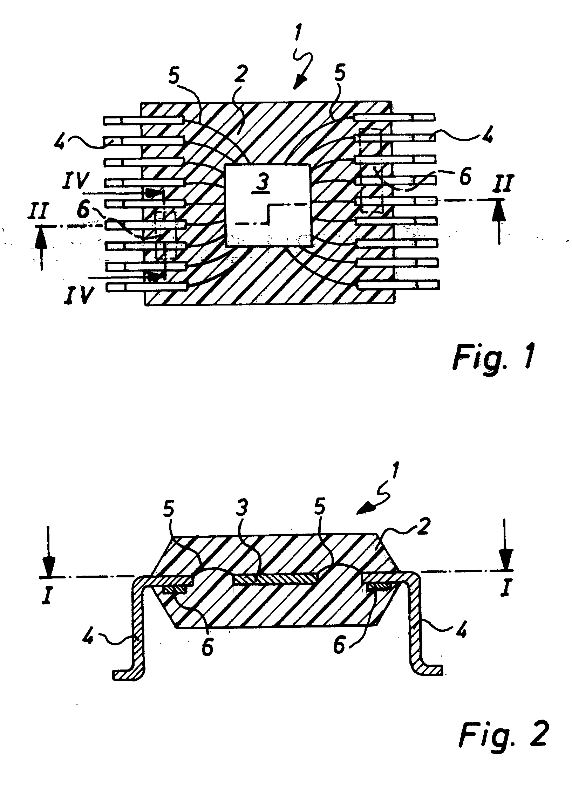

In den Figuren 1 und 2 ist ein elektrisches oder opto-elektrisches Bauelement gemäß einer ersten Ausführungsform der vorliegenden Erfindung in seiner Gesamtheit mit dem Bezugszeichen 1 bezeichnet. Das Bauelement 1 weist eine Verpackung 2 aus Kunststoff und einen in der Verpackung 2 angeordneten elektrischen oder opto-elektrischen integrierten Schaltkreis 3 auf. Aus der Verpackung 2 ragen seitlich Anschlussleitungen 4 heraus, die einerseits mit Anschlüssen des Schaltkreises 3 kontaktiert sind. In dem vorliegenden Ausführungsbeispiel erfolgt die Kontaktierung mittels sogenannter Bonding-Drähte 5. Andererseits sind die Anschlussleitungen 4 mit entsprechenden Kontakten des Schaltkreises 3 kontaktiert. Die Anschlussleitungen 4 dienen zum Anschluss des Schaltkreises 3 an eine Schaltung, die bspw. auf einer Leiterplatte ausgebildet ist und in die das Bauelement 1 integriert werden soll. Das Bauelement 1 wird beispielsweise mittels eines geeigneten Sockels oder mittels Lötverbindungen auf der Leiterplatte befestigt und mit der Schaltung kontaktiert.

Das Bauelement 1 weist außerdem zwei dielektrische Platten 6 auf, die an mindestens zwei der Anschlussleitungen 4 befestigt sind. Die dielektrische Platte 6' ist an zwei und die dielektrische Platte 6" ist an vier Anschlussleitungen 4 befestigt. Durch die dielektrischen Platten 6 kann die Impedanz der Anschlussleitungen 4, an denen eine dielektrische Platte 6 befestigt ist, erniedrigt werden. Im vorliegenden Ausführungsbeispiel kann die Impedanz von einem Wert, der typischerweise über etwa 100 Ω liegt, auf den Wert der Impedanz der übrigen Schaltung, in die das Bauelement 1 integriert ist, und des Schaltkreises 3, der typischerweise bei 25 Ω oder 50 Ω liegt, verringert werden.

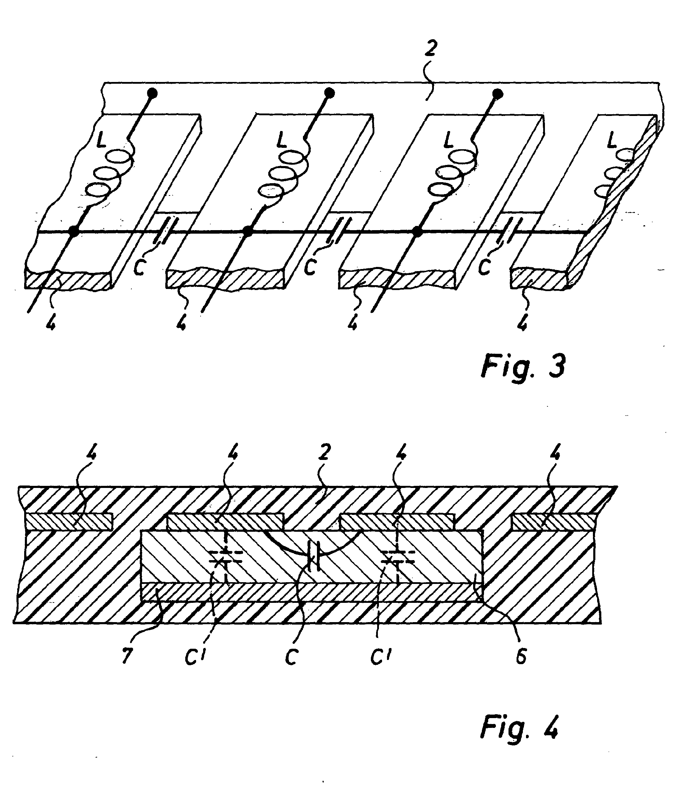

Das Verringern der Impedanz der Anschlussleitungen 4 ist insbesondere bei einem Einsatz des Bauelements 1 in Hochgeschwindigkeits-Anwendungen mit Bit-Raten von bis zu mehreren Gb/s und Hochfrequenz-Anwendungen von bis zu mehreren GHz. Bei solchen Anwendungen sollte impedanzkontrolliert gearbeitet werden, d.h. die Impedanz der Anschlussleitungen 4 sollte auf die Impedanz des Schaltkreises 3 und der gesamten Schaltung, in die das Bauelement 1 integriert ist, angepasst sein. Mit Hilfe der dielektrischen Platten 6 kann die Impedanz der Anschlussleitungen 4 verringert werden, was im folgenden anhand der Figuren 3 und 4 näher erläutert wird.

In Figur 3 ist ein Ausschnitt des erfindungsgemäßen Bauelements 1 aus den Figuren 1 und 2 in perspektivischer Ansicht dargestellt. Es sind die Verpackung 2 aus Kunststoff und mehrere Anschlussleitungen 4 zu erkennen. Diesem Ausschnitt des Bauelements 1 ist ein Ersatzschaltbild für die Anschlussleitungen 4 überlagert. Das Ersatzschaltbild weist Kapazitäten C zwischen nebeneinander angeordneten Anschlussleitungen 4 und Induktivitäten L entlang der Anschlussleitungen 4 auf. Die Impedanz Z der Anschlussleitungen 4 ist proportional zu der Wurzel aus dem Quotienten der Induktivität L und der Kapazität C. Durch Erhöhen der Kapazität C kann als die Impedanz Z einer Anschlussleitung 4 verringert werden.

Die Kapazität C zwischen zwei nebeneinander verlaufenden Anschlussleitungen 4 ist proportional zu der Permittivitätszahl (Dielektrizitätskonstante) Epsilon_r des zwischen den beiden Anschlussleitungen 4 befindlichen Mediums. Luft hat eine Permittivitätszahl von etwa 1 und Kunststoff von etwa 2,5 bis 6. Die Permittivitätszahl von Glas beträgt etwa 4. Bei einer aus Keramik, vorzugsweise aus Aluminiumoxid (Al₂O₃), bestehenden dielektrischen Platte 6 beträgt die Permittivitätszahl Epsilon_r etwa 5 bis 10. Bei speziellen Keramikmaterialien kann die Permittivitätszahl Werte bis zu 1000 erreichen. Somit kann durch Befestigen einer dielektrischen Platte 6 an mindestens einer Anschlussleitung 4 die gemäß Ersatzschaltbild zwischen zwei Anschlussleitungen 4 ausgebildete Kapazität C deutlich erhöht werden, was zu einer verringerten Impedanz Z der Anschlussleitungen 4 führt.

Die Kapazität C kann noch einmal deutlich erhöht werden, wenn auf der den Anschlussleitungen 4 gegenüberliegenden Oberfläche der dielektrischen Platten 6 eine Metallschicht 7 aufgebracht ist. In diesem Fall wirken die Anschlussleitungen 4 und die Metallschicht 7 gewissermaßen als Plattenkondensator. Die Kapazitäten C' des Plattenkondensators sind in Figur 4 gestrichelt dargestellt.

Selbstverständlich können sämtliche Anschlussleitungen 4 des Bauelements 1 mit einer dielektrischen Platte 6 versehen werden, um die Impedanz Z sämtlicher Anschlussleitungen 4 zu verringern. Sinnvollerweise wird jedoch nur an denjenigen Anschlussleitungen 4 des Bauelements 1 eine dielektrische Platte 6 befestigt, über die Signale mit einer hohen Datenübertragungsrate (mehrere Gb/s) oder mit einer hohen Frequenz (mehrere GHz) übertragen werden. Bei diesen Anschlussleitungen 4 zur Signalübertragung ist es besonders wichtig, dass impedanzkontrolliert gearbeitet wird, d. h. dass die Impedanz Z der Anschlussleitungen 4 auf die Impedanz des Schaltkreises 3, der Schaltung, in die das Bauelement 1 integriert ist, und der übrigen Bauelemente der Schaltung abgestimmt ist.

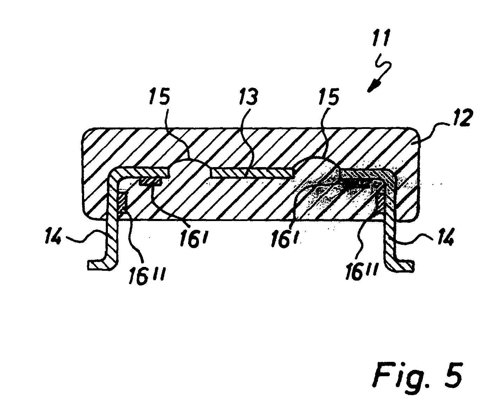

In Figur 5 ist ein erfindungsgemäßes Bauelement 11 gemäß einer zweiten bevorzugten Ausführungsform dargestellt. Bei dem Bauelement 11 ist eine Kunststoff-Verpackung 12 seitlich derart über Anschlussleitungen 14 gezogen, dass die Anschlussleitungen 14 an der Unterseite des Bauelements 11 aus der Verpackung 12 heraustreten. Allein durch die Tatsache, dass die Anschlussleitungen 14 über eine größere Länge mit dem Kunststoff der Verpackung 12 umgeben sind als bei dem ersten Ausführungsbeispiel (vgl. Figur 2), führt zu einer deutlich höheren Kapazität C des Ersatzschaltbildes und damit zu einer deutlich niedrigeren Impedanz Z der Anschlussleitungen 14. Außerdem können mehrere - in dem vorliegenden Ausführungsbeispiel zwei - dielektrische Platten 16', 16" entlang der Anschlussleitungen 14 angeordnet und an diesen befestigt werden. Dadurch kann die Impedanz Z der Anschlussleitungen 14 auf einen besonders niedrigen und gleichmäßigen Wert entlang der Anschlussleitungen 14 verringert werden.

Die dielektrischen Platten 6, 16 werden während der Herstellung der Verpackung 2, 12 des Bauelements 1, 11 einfach an den Anschlussleitungen 4, 14 zur Auflage gebracht und dann durch Vergießen mit Kunststoff in dieser Position fixiert. Die gesamte Herstellung des erfindungsgemäßen Bauelements 1, 11 kann mit den bisherigen Maschinen erfolgen. Es muss lediglich ein zusätzlicher Schritte zur Anordnung der dielektrischen Platten 6, 16 auf den Anschlussleitungen 4, 14 vorgesehen werden. Die Anordnung und Abmessung der Anschlussleitungen 4, 14 des erfindungsgemäßen Bauelements 1, 11 ist identisch mit denen aus dem Stand der Technik bekannten Bauelementen mit einer Verpackung aus Kunststoff. Dadurch können die erfindungsgemäßen Bauelemente 1, 11 ohne Weiteres in Schaltungen integriert werden, die für die bisher üblichen Bauelemente gedacht waren. Durch die verringerte Impedanz der Anschlussleitungen 4, 14 bei den erfindungsgemäßen Bauelementen 1, 11 ergibt sich jedoch insbesondere bei Hochgeschwindigkeits- und Hochfrequnez-Anwendungen eine deutliche Verringerung von störenden Signal-Reflexionen in dem Schaltkreis 3, 13 oder in der Schaltung auf der Leiterplatte, in die das Bauelement 1, 11 integriert ist.

## Patentansprüche

1. Elektrisches oder opto-elektrisches Bauelement (1, 11) mit einer Verpackung (2, 12) aus Kunststoff, mindestens einem in der Verpackung (2, 12) angeordneten elektrischen oder opto-elektrischen integrierten Schaltkreis (3, 13) und aus der Verpackung (2, 12) herausragenden Anschlussleitungen (4, 14) zum Anschluss des oder jeden Schaltkreises (3, 13), **dadurch gekennzeichnet, dass** mindestens eine dielektrische Platte (6, 16', 16") an mindestens einer der Anschlussleitungen (4, 14) befestigt ist.

2. Bauelement (1, 11) nach Anspruch 1, **dadurch gekennzeichnet, dass** die oder jede dielektrische Platte (6, 16', 16") in der Verpackung (2, 12) angeordnet ist.

3. Bauelement (1, 11) nach Anspruch 1 oder 2, **dadurch gekennzeichnet, dass** die oder jede dielektrische Platte (6, 16', 16") eine höhere Permittivitätszahl (Epsilon_r) als der Kunststoff der Verpackung (2, 12) aufweist.

4. Bauelement (1, 11) nach Anspruch 3, **dadurch gekennzeichnet, dass** die oder jede dielektrische Platte (6, 16', 16") aus Keramik, vorzugsweise aus Aluminiumoxid (Al2O3), besteht.

5. Bauelement (1, 11) nach einem der Ansprüche 1 bis 4, **dadurch gekennzeichnet, dass** die Verpackung (2, 12) seitlich über die Anschlussleitungen (4, 14) gezogen ist.

6. Bauelement (1, 11) nach einem der Ansprüche 1 bis 5, **dadurch gekennzeichnet, dass** die den Anschlussleitungen (4, 14) abgewandte Oberfläche der oder jeder dielektrischen Platte (6, 16', 16") zumindest teilweise mit einer Metallschicht (7) beschichtet ist.

7. Bauelement (11) nach einem der Ansprüche 1 bis 6, **dadurch gekennzeichnet, dass** zwei dielektrische Platten (16', 16") an den Anschlussleitungen (14) befestigt sind.

8. Verwendung einer dielektrischen Platte (6, 16', 16") zur Variation der Impedanz (Z) einer Anschlussleitung (4, 14) eines elektrischen oder opto-elektrischen Bauelements (1, 11), das eine Verpackung (2, 12) aus Kunststoff, mindestens einen in der Verpackung (2, 12) angeordneten elektrischen oder opto-elektrischen integrierten Schaltkreis (3, 13) und mehrere aus der Verpackung (2, 12) herausragende Anschlussleitung (4, 14) zum Anschluss des oder jeden Schaltkreises (3, 13) aufweist, wobei die dielektrische Platte (6, 16', 16") an der Anschlussleitung (4, 14) befestigt wird.

9. Verfahren zur Variation der Impedanz (Z) einer Anschlussleitung (4, 14) eines elektrischen oder opto-elektrischen Bauelements (1, 11), wobei das Bauelement (1, 11) eine Verpackung (2, 12) aus Kunststoff, mindestens einen in der Verpackung (2, 12) angeordneten elektrischen oder opto-elektrischen integrierten Schaltkreis (3, 13) und die aus der Verpackung (2, 12) herausragenden Anschlussleitungen (4, 14) zum Anschluss des oder jeden Schaltkreises (3, 13) aufweist, **dadurch gekennzeichnet, dass** mindestens eine dielektrische Platte (6, 16', 16") an mindestens einer der Anschlussleitungen (4, 14) befestigt wird.
